# EUROPÄISCHE PATENTSCHRIFT

(11) **EP 3 236 196 B1**
(45) Veröffentlichungstag und Bekanntmachung des Hinweises auf die Patenterteilung: **08.05.2019**
(21) Anmeldenummer: 17162496.8
(22) Anmeldetag: 23.03.2017
(51) Int. Cl.: G01B 7/14, B23K 26/38, B23K 26/382, B23K 26/40, B23K 26/04, B23K 26/0622, B23K 26/03, B23K 103/04, B23K 103/10, B23K 103/12

(54) **VERFAHREN UND VORRICHTUNG ZUR DURCHSTICH-ERKENNUNG BEIM THERMISCH UNTERSTÜTZTEN DURCHSTECHEN EINES WERKSTÜCKS**
METHOD OF AND DEVICE FOR PIERCING DETECTION IN THERMALLY ASSISTED PIERCING OF A WORKPIECE
PROCÉDÉ ET DISPOSITIF DE DÉTECTION DE PERFORATION LORS DE LA PERFORATION THERMIQUE D'UNE PIÈCE USINÉE

(30) Priorität: 24.03.2016 DE 102016105560
(43) Veröffentlichungstag der Anmeldung: 25.10.2017
(73) Patentinhaber: Messer Cutting Systems GmbH, 64823 Gross-Umstadt (DE)
(72) Erfinder: BAYRAM, Murat Cetin, 64720 Michelstadt (DE); MÜLLER, Thomas, 64823 Gross-Umstadt (DE)
(74) Vertreter: Staudt, Armin Walter

(56) Entgegenhaltungen:
- WO-A1-2017/085000
- DE-A1-102010 039 525
- US-A1- 2014 312 018

## Beschreibung

### Technisches Gebiet

Die vorliegende Erfindung betrifft ein Verfahren zur Durchstich-Erkennung beim thermisch-unterstützten Durchstechen eines Werkstücks, bei dem das Werkstück mit einem ersten Wechselsignal beaufschlagt wird (siehe Anspruch 1).

Weiterhin betrifft die vorliegende Erfindung eine Vorrichtung zur Durchstich-Erkennung beim thermisch-unterstützten Durchstechen eines Werkstücks, aufweisend einen Wechselsignal-Generator zum Erzeugen eines ersten Wechselsignals (siehe Anspruch 10).

### Stand der Technik

Das thermische Schneiden von Werkstücken erfolgt in der Regel durch den kombinierten Einsatz eines fokussierten Laserstrahls und eines Gasstrahls. Dabei wird je nach Trennmechanismus zwischen Laserstrahl-Schmelzschneiden, Laserstrahl-Verdampfungsschneiden oder Laser-Brennschneiden unterschieden. Weit verbreitet ist das Laserstrahl-Schmelzschneiden. Dabei erfolgt die Materialtrennung, indem der Werkstoff durch die Heizleistung des Laserstrahls im Bereich der Schneidfront aufgeschmolzen und durch den gleichzeitigen Impulsübertrag des Schneidgasstrahls aus der Schnittfuge ausgetrieben wird. Es werden Hochleistungslaser, insbesondere CO₂-, Faser-, Scheiben- und Diodenlaser eingesetzt, wobei überwiegend zirkular polarisierte oder unpolarisierte Laserstrahlung verwendet wird, um eine Richtungsabhängigkeit im Absorptionsverhalten bei Konturschnitten zu vermeiden.

Beim Einstech- oder Durchstechvorgang wird ein erstes Loch in dem Werkstück erzeugt. Dabei wird für gewöhnlich mit Laserstrahlung nur im Pulsbetrieb gearbeitet, um so schnell wie möglich, gleichzeitig aber so schonend wie möglich, in das Material einzustechen. Problemtisch ist die Erkennung des erfolgten Durchstichs. Bei einem von Hand programmierten Einstechvorgang sind für jede spezifische Konstellation von Werkstückart und -dicke die Einstechparameter einschließlich der typischen Einstechdauer in einer Datenbank hinterlegt. Dabei muss jedoch aufgrund nicht vorhersehbarer Materialabweichungen und Veränderungen im Prozess die Einstechdauer mit einem zeitlichen Sicherheitspuffer versehen werden. Der Sicherheitspuffer soll gewährleisten, dass im Produktionsbetrieb die Zeit zwischen Einstechbeginn und Schneiden nicht zu kurz gewählt ist und Ausschuss produziert wird. Ist die Zeit jedoch zu lang, verlängert sich die Gesamtzeit zur Bearbeitung unnötig und trotz eigentlich beendetem Einstechvorgang wird weitere Prozessenergie in das Werkstück eingeführt. Diese Energie kann die Eigenschaften des Materials verändern und erschwert die reproduzierbare Einhaltung einer gleichbleibenden Schnittqualität.

Diesen Nachteil vermeiden Einrichtungen zur automatischen Erkennung des erfolgten Durchstichs. Diese Einrichtungen verfügen beispielsweise über einen optischen Sensor, der das zurückgestreute Licht beim Einstechvorgang erfasst und eine Änderung des Rückstreulichts oberhalb eines Schwellwertes als Abschluss des Einstechvorgangs interpretiert. Der Einsatz optischer Sensoren erfordert allerdings einen gewissen Bauraum. Darüber hinaus sind die Sensoren entweder in der Nähe des Werkstücks angeordnet, so dass sie unter Trennbedingungen hohen thermischen Beanspruchungen ausgesetzt sind oder sie sind in einem Abstand zum Trennprozess angeordnet, was zu einem ungünstigen Signal/Rauschverhältnis führt, so dass das Signal des Sensors in der Regel verstärkt werden muss. Des Weiteren haben optische Sensoren den Nachteil, dass es Einflussfaktoren im Strahlgang gibt, die das Sensor-Signal verändern, beispielsweise der Düsendurchmesser.

Einen anderen Weg beschreitet die DE 10 2010 039 525 A1 (Basis für den Oberbegriff der Ansprüche 1 und 10), aus der ein Verfahren und eine Vorrichtung zur Durchstich-Erkennung gemäß der eingangs genannten Gattung bekannt sind. Für die automatische Erkennung des Durstichs wird ein kapazitiver Abstandssensor eingesetzt, wie er auch der während des Schneidvorgangs zur berührungslosen Abstandsmessung eingesetzt wird und dabei einen Abstand zwischen Laserdüse und Werkstück-Oberseite gewährleistet. Bei dem kapazitiven Abstandsmesssystem bilden der metallische Abstandsensor und das das metallische Werkstück einen variablen Kondensator, der in einen LC-Schwingkreis eingebunden ist. Wird das Werkstück mit einem ersten Wechselsignal beaufschlagt, so wird die Kapazität dieses Kondensators durch Abstand zwischen Sensor und Werkstück bestimmt. Beim Überfahren des Werkstücks im Bereich des Durchbruchs detektiert der Abstandsensor aufgrund der plötzlichen Abstandsänderung, dass ein Durchstich in dem Werkstück gebildet worden ist.

Aus der US 2014/0312018 A1 ist ein Verfahren zur dynamischen Höhenanpassung für den Schneidkopf eines Laserbearbeitungssystems mit folgenden Verfahrensschritten bekannt: Positionieren eines kapazitiven im Schneidkopf beanstandet vom zu bearbeitenden Werkstück, wobei der Sensor eine Düse und einen isolierten Sensorblock umfasst; Erzeugen eines ersten und eines zweiten frequenzgleichen aber phasenverschiedenen Signals; Anlegen des ersten Signals an besagten kapazitiven Sensor und Aufzeichnen einer infolge der KapazitätsÄnderung bewirkten Phasenverschiebung im ersten Signal als Maß für die relative Position des Schneidkopfes zum Werkstück; Anpassen des zweites Signals an einen festen Wert, der etwa minus 90° phasenverschoben zum ersten Signal ist; Bestimmen der Phasenverschiebung im ersten Signal infolge einer Änderung der Kapazität im kapazitiven Sensor durch Auswertung der besagten Phasenverschiebung beim ersten Signal gegenüber dem Festwert beim phasenverschobenen zweiten Signal; und Vergleichen der Kapazitätsänderung mit einer Eichkurve zur Schneidkopf-Höhe in Abhängigkeit von der Phasenverschiebung.

Die WO 2017/085000 A1, die gemäß Art. 54 (3) EPÜ zum Stand der Technik gehört, beschreibt ein Verfahren zum Erkennen eines drohenden oder erfolgten Schnittabrisses beim thermischen Trennen eines Werkstücks. Es umfasst die obigen Verfahrensschritte: Beaufschlagen des Werkstücks mit einem ersten Wechselsignal; Erfassen eines zweiten Wechselsignals in einer vom Werkstück beabstandeten Messelektrode, das hervorgerufen wird vom ersten Wechselsignal, Ermitteln der Phasenverschiebung zwischen erstem und zweitem Wechselsignal unter Ausgabe eines Phasenverschiebungssignals, und Erfassen des zeitlichen Verlaufs des Phasenverschiebungssignals in einem vorgegebenen Zeitintervall, Der Schnittabriss wird daran erkannt, dass das Phasenverschiebungssignal einen oberen Grenzwert überschreitet oder einen unteren Grenzwert unterschreitet.

### Technische Aufgabe

Bei dem aus DE 10 2010 039 525 A1 bekannten Verfahren hängt die Durchstich-Erkennung im Wesentlichen von der Erfassung des Amplitudenanstiegs im LC-Generator-Ausgangssignal ab. Allerdings wird die Amplitudenhöhe von einer Vielzahl von Faktoren beeinflusst, beispielsweise von den im Schwingkreis vorhandenen Widerständen und der Größe des Zwischenraums, insbesondere aber durch den Abstand zwischen Werkstück und Sensor (der im Folgenden auch als "Messelektrode" bezeichnet wird.)

Das LC-Generator-Ausgangssignal weist häufig ein Hintergrundrauschen auf. Erschwerend kommt hinzu, dass sich beim Einstechen auf der Oberseite des Werkstücks eine Plasmakapsel aus geladenen Teilchen bildet. Die Bildung des Plasmas verursacht eine Störung der Kapazität zwischen Messelektrode und Werkstückoberseite, was zu einem schwankenden Spannungssignal führt. Eine weitere Ursache hierfür sind gelöste Materialbestandteile die aus dem Einstechkrater in Richtung der Messelektrode geschleudert werden.

Dies erschwert eine exakte, insbesondere eine frühzeitige Erfassung des Durchstichs.

Der Erfindung liegt daher die Aufgabe zugrunde, ein Verfahren anzugeben, das eine frühzeitige Erkennung des bevorstehenden oder erfolgten Durchstichs ermöglicht.

Weiterhin liegt der Erfindung die Aufgabe zugrunde, eine Vorrichtung zur Durchführung des Verfahrens bereit zu stellen.

### Allgemeine Beschreibung der Erfindung

Hinsichtlich des Verfahrens wird die oben genannte Aufgabe erfindungsgemäß durch ein Verfahren gelöst, das folgende Verfahrensschritte umfasst:
a) Erfassen eines von dem ersten Wechselsignal in einer vom Werkstück beabstandeten Messelektrode hervorgerufenen, zweiten Wechselsignals
b) Ermitteln der Phasenverschiebung zwischen erstem und zweitem Wechselsignal unter Ausgabe eines Phasenverschiebungssignals, und
c) Erfassen eines zeitlichen Verlaufs des Phasenverschiebungssignals oder einer daraus abgeleiteten Messgröße in einem vorgegebenen Zeitintervall,
wobei ein erfolgter Werkstück-Durchstich daran erkannt wird, dass das Phasenverschiebungssignal oder die daraus abgeleitete Messgröße im Zeitintervall innerhalb eines vorgegebenen Schwankungsbereichs liegt.

Der Erfindung liegt die Idee zugrunde, einen Durchstich möglichst frühzeitig, vorzugsweise noch in seiner Entstehung, zu erkennen. Im Gegensatz zu bekannten Verfahren mit einem LC-Schwingkreis wird auf eine Auswertung des Amplitudensignals verzichtet. Stattdessen wird gemäß der Erfindung eine Differenz-Messmethode zur Durchsticherkennung angewandt, bei der zwei Signale verwendet und deren Phasenverschiebung zueinander bestimmt wird, nämlich ein Messsignal, das von einer Messelektrode ausgegeben wird und ein Referenzsignal, auf das das Messsignal der Messelektrode bezogen wird. Durch den Vergleich der Phasenlage von Messsignal und Referenzsignal wird das Phasenverschiebungssignal erzeugt. Dies ist ein bereinigtes Auswertungssignal, in dem Messfehler eliminiert sind, und das ein besonders gutes Signal-Rausch-Verhältnis aufweist.

Zu diesem Zweck wird das Werkstück zunächst mit einem zeitlich veränderlichen Signal (erstes Wechselsignal) beaufschlagt. Vorzugsweise ist das erste Wechselsignal ein Wechselspannungssignal *U₁ (t).* Das erste Wechselsignal erzeugt in einer in einem Abstand zum Werkstück angeordneten Elektrode ein zweites Wechselsignal, beispielsweise ein Wechselstromsignal *I_{1,ϕ} (t)*, das als Messsignal verwendet wird, und das gegenüber dem ersten Wechselsignal (Referenzsignal) eine Phasenverschiebung aufweist. Um die Phasenverschiebung möglichst exakt erfassen zu können, wird das erste Wechselsignal als Referenzsignal verwendet. Die Phasenverschiebung wird durch einen Vergleich des ersten Wechselsignals mit dem zweiten Wechselsignal ermittelt.

Es hat sich gezeigt, dass das Phasenverschiebungssignal von der zwischen Messelektrode und dem Werkstück gebildeten Kapazität abhängt. Mit zunehmendem Abstand der Messelektrode zum Werkstück nimmt der Betrag des Phasenverschiebungssignals zu. Bei konstantem Abstand von Messelektrode und Werkstück wird die Kapazität vornehmlich von der Dielektrizitätskonstanten des Dielektrikums bestimmt.

Infolge der Plasmakapsel, die sich vor dem Durchstich im Zwischenraum zwischen Messelektrode und Werkstück bildet, ändert sich laufend die Zusammensetzung des Dielektrikums und damit die von Messelektrode und damit das Phasenverschiebungssignal. Verschwindet die Plasmakapsel, so ändert sich die Zusammensetzung des Dielektrikums nicht mehr und das Phasenverschiebungssignal ist konstant. Liegt das Phasenverschiebungssignal innerhalb eines vorgegebenen Zeitintervalls innerhalb eines vorgegebenen Schwankungsbereichs, so dient dies als Indikator für den erfolgten Durchstich.

Hierbei hat es sich bewährt, wenn das als Referenzsignal dienende erste Wechselsignal zur Ermittlung der Phasenverschiebung zunächst invertiert, die Amplitude von erstem und zweitem Wechselsignal aufeinander abgestimmt und angeglichen werden und das erste und das zweite Wechselsignal anschließend addiert werden. In diesem Fall heben sich, sofern keine Phasenverschiebung vorliegt, erstes und zweites Wechselsignal auf. Liegt allerdings eine Phasenverschiebung vor, so wird ein Phasenverschiebungssignal erhalten, dessen Höhe und Richtung von der Phasenverschiebung abhängt. Das Phasenverschiebungssignal ändert sich bei einer Abstandsänderung von Messelektrode zu Werkstück und bei einer Änderung des Dielektrikums durch Plasmabildung im Zwischenraum.

Um eine Verfälschung des Phasenverschiebungssignals durch Abstandsänderungen zu vermeiden, wird die Messelektrode während des thermisch-unterstützten Durchstechens bevorzugt in einem konstanten Arbeitsabstand zum Werkstück gehalten.

Dabei wird vorteilhafterweise vor dem thermischen Durchstechen mit der auf Arbeitsabstand gehaltenen Messelektrode ein Ausgangs-Phasenverschiebungssignalwert bestimmt, wobei d er vorgegebene Schwankungsbereich den Ausgangs-Phasenverschiebungssignalwert umfasst.

Der Ausgangs-Phasenverschiebungssignalwert wird vorzugsweise ermittelt, bevor der Laserstrahl auf das Werkstück einwirkt.

Er liegt innerhalb des vorgegebenen Schwankungsbereichs und zwar idealerweise in dessen Mitte. Insoweit ist eine Verfahrensweise bevorzugt, bei der der vorgegebene Schwankungsbereich einen dem Ausgangs-Phasenverschiebungssignalwert entsprechenden Mittelwert aufweist, wobei der vorgegebene Schwankungsbereich in einem Bereich von ± 5% bis ±15%bezogen den Mittelwert liegt.

Es hat sich bewährt, wenn gemäß Verfahrensschritt c) die Varianz des Phasenverschiebungssignals im vorgegebenen Zeitintervall als abgeleitete Messgröße erfasst wird.

Im Hinblick auf eine besonders geringes Rauschen und eine hohe Messgenauigkeit hat es sich aber als besonders günstig erwiesen, wenn gemäß Verfahrensschritt c) die erste zeitliche Ableitung des Phasenverschiebungssignals im vorgegebenen Zeitintervall erfasst und als abgeleitete Messgröße verwendet wird.

Darüber hinaus kann mittels der Erfindung auch ein noch nicht erfolgter aber bevorstehender Durchstich erkannt und gegebenenfalls darauf reagiert werden. Diese Möglichkeit beruht darauf, dass die Plasmakapsel im Verlauf des Durchstich-Vorgangs und zunehmender Materialaufschmelzung im Einstechkrater ganz oder teilwiese verschwinden kann. Dadurch-verändert sich der Einfluss der Plasmakapsel auf das Phasenverschiebungssignal, das sich deswegen zu merklich höheren und niedrigeren Spannungen hin verschiebt. Dieses Phänomen macht sich besonders bei Werkstücken mit größeren Materialstärken bemerkbar, in der Regel bei Materialstärken oberhalb von 10 mm. Ob die Verschiebung zu höheren oder zu niedrigeren Spannungen erfolgt, hängt von der Werkstückdicke und von der Materialart ab.

Im Hinblick darauf ist bei eine besonders bevorzugten Verfahrensweise vorgesehen, dass beim thermisch-unterstützten Durchstechen des Werkstücks mittels einer Bearbeitungseinheit ein Energieeintrag in einen Einstichkrater erfolgt, und dass eine Überwachung des Durchstechens dergestalt erfolgt, dass, wenn der gemäß Verfahrensschritt c) erfasste zeitliche Verlauf im vorgegebenen Zeitintervall einen vorgegebenen Höchstschwankungsbereich überschreitet oder wenn im zeitlichen Verlauf gemäß Verfahrensschritt c) ein Spitzenwert oberhalb eines vorgegebenen Spitzenhöchstwerts erfasst wird, der Energieeintrag in den Einstichkrater verändert wird.

Der Energieeintrag in den Einstichkrater bei bevorstehendem Durchstich wird dabei verringert oder erhöht. Wird er verringert, so wird das Werkstück geschont und ein sauberer Durchstich erhalten. Wird er erhöht, so wird der Durchstichvorgang beschleunigt.

Der Energieeintrag in den Einstichkrater kann verändert werden, indem der Abstand von Bearbeitungseinheit und Werkstück verringert oder vergrößert wird. Diese Maßnahme verändert aber auch das Phasenverschiebungssignal, so dass die Änderung des Energieeintrags bevorzugt über andere Maßnahmen erfolgt.

Für den Fall, dass die Bearbeitungseinheit einen Laser umfasst, hat es sich beispielsweise bewährt, wenn der Energieeintrag in den Einstichkrater verändert wird, indem Fokuslage, Pulsfrequenz, Leistung und/oder Tastverhältnis des Lasers verändert werden.

Umfasst hingegen die Bearbeitungseinheit einen Schneidbrenner, so kann der Energieeintrag in den Einstichkrater auch dadurch verändert werden, indem ein Gasdruck, vorzugsweise ein Schneidgasdruck erhöht oder erniedrigt wird.

Die Einleitung der Phase mit verringertem Energieeintrag in den Einstichkrater kann zu einer Bedienermeldung führen, um dem Bedienpersonal optisch oder akustisch die veränderten Bedingungen anzuzeigen, so dass bei einer Fehlinterpretation manuell eingegriffen werden kann.

Hinsichtlich der Vorrichtung zur Durchstich-Erkennung beim thermisch-unterstützten Durchstechen eines Werkstücks wird die oben genannte Aufgabe erfindungsgemäß durch eine Modifikation der Vorrichtung der eingangs genannten Gattung gelöst, die eine vom Werkstück beabstandete Messelektrode zur Erfassung eines von dem ersten Wechselsignal hervorgerufenen zweiten Wechselsignals, einen Phasen-Diskriminator zur Ermittlung einer Phasenverschiebung zwischen dem ersten und dem zweiten Wechselsignal, der ein Phasenverschiebungssignal ausgibt, umfasst, und wobei eine elektronische Schaltung zur Erfassung eines zeitlichen Verlauf des Phasenverschiebungssignals oder einer daraus abgeleiteten Messgröße vorgesehen und derart ausgelegt ist, dass als Werkstück-Durchstich identifiziert wird, wenn das Phasenverschiebungssignal oder die daraus abgeleitete Messgröße in einem vorgegebenen Zeitintervall innerhalb eines vorgegebenen Schwankungsbereichs liegt.

Die Vorrichtung ermöglicht eine frühzeitige Erkennung des bevorstehenden oder erfolgten Durchstichs. Hierzu ist ein Wechselsignal-Generator vorgesehen, der geeignet ist, ein erstes Wechselsignal zu erzeugen, mit dem das Werkstück beaufschlagt werden kann. Vorzugsweise ist das erste Wechselsignal ein Wechselspannungssignal *U₁ (t).* Das erste Wechselsignal ruft in einer in einem Abstand zum Werkstück angeordneten Elektrode ein zweites Wechselsignal hervor, das mit einer Messelektrode erfasst wird, die zum Werkstück einen Abstand aufweist. Das zweite Wechselsignal, beispielsweise ein Wechselstromsignal *I_{1,ϕ} (t)*, und das erste Wechselsignal *U₁ (t)* liegen als Messsignal an einem Phasendiskriminator an, der ein Phasenverschiebungssignal ausgibt, aus dem die Phasenverschiebung beider Signale ableitbar ist. Es hat sich gezeigt, dass die Phasenverschiebung von der von der Messelektrode und dem Werkstück gebildeten Kapazität abhängt, die bei konstantem Abstand von Messelektrode und Werkstück vornehmlich von der Dielektrizitätszahl des Dielektrikums bestimmt wird.

Da sich vor dem Durchstich im Zwischenraum zwischen Messelektrode und Werkstück Plasma bildet, ändert sich die Zusammensetzung des Dielektrikums und damit die von Messelektrode und Werkstück gebildete Kapazität. Durch die geänderte Kapazität erfolgt eine Änderung des Phasenverschiebungssignals. Bei erfolgtem Durchstich verschwindet die Plasmakapsel und das Phasenverschiebungssignal ist konstant. Die elektronische Schaltung ist daher so ausgelegt, dass sie den zeitlichen Verlauf des Phasenverschiebungssignals überwacht und als Indikator für den erfolgten Durchstich wertet, wenn das Phasenverschiebungssignal während einer vorgegebenen Zeitspanne innerhalb des ebenfalls vorgegebenen Schwankungsbereichs liegt.

Die Messelektrode befindet sich nahe am eigentlichen Schneidprozess, was sich günstig auf das Signal/Rausch-Verhältnis auswirkt. Die Vorrichtung ist insbesondere zur Durchführung des erfindungsgemäßen Verfahrens ausgelegt, so dass die diesbezüglichen Erläuterungen auch für die erfindungsgemäße Vorrichtung zutreffen.

### Ausführungsbeispiel

Nachfolgend wird die Erfindung anhand von Ausführungsbeispielen und einer Zeichnung näher beschrieben. Im Einzelnen zeigt:
- **Figur 1**: ein Aufbauschema einer erfindungsgemäßen Vorrichtung zur Durchstich-Erkennung,
- **Figur 2**: ein erstes Diagramm, in dem ein Phasenverschiebungssignal in Abhängigkeit von der Zeit dargestellt ist,
- **Figur 3**: ein zweites Diagramm, in dem ein Phasenverschiebungssignal in Abhängigkeit von der Zeit dargestellt ist,
- **Figur 4**: zur Erläuterung des Verfahrens zur Durchstich-Erkennung eine Anordnung aus Werkstück und Vorrichtung zur Durchsticherkennung in zeitlicher Abfolge vor, während und nach einem Durchschnitt,
- **Figur 5**: einen Laserschneidkopf mit einer erfindungsgemäße Vorrichtung zur Durchstich-Erkennung und einem Abschirmelement,
- **Figur 6**: ein schematisches Schaltbild einer erfindungsgemäßen Vorrichtung zur Durchstich-Erkennung, die auch zur Schnittabrisserkennung einsetzbar ist,
- **Figur 7**: einen Ausschnitt aus des Schaltbildes von Figur 6 bei einem Schnittabriss, und
- **Figur 8**: ein Diagramm, in dem ein Phasenverschiebungs-Gleichspannungssignal während eines Schneidvorgangs in Abhängigkeit von der Zeit dargestellt ist.

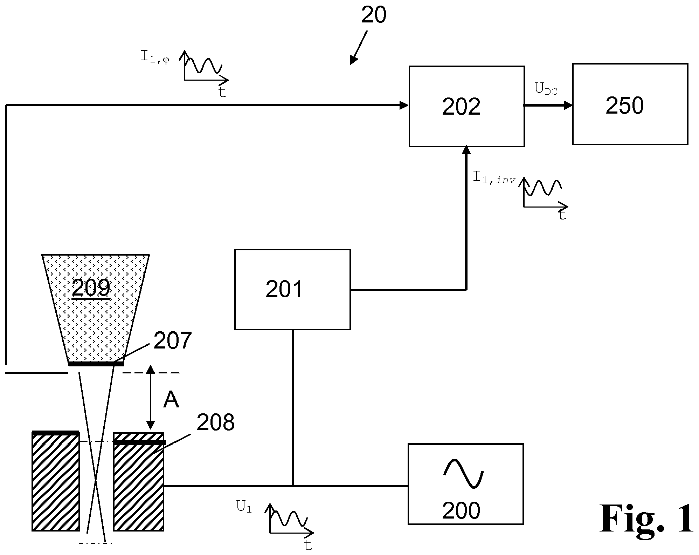

Der in **Figur 1** schematisch gezeigten Vorrichtung zur Durchstich-Erkennung ist insgesamt die Bezugsziffer 20 zugeordnet. Die Vorrichtung 20 umfasst einen Wechselsignalgenerator 200, eine Messelektrode 207, einen Invertierer 201, einen Phasendiskriminator 202 und eine elektronische Schaltung 250, die zur Erkennung eines erfolgten Durchstichs ausgelegt ist.

Die Vorrichtung 20 ist Teil einer Laserschneidmaschine und wird bei der thermischen Bearbeitung eines Werkstücks 208 zur Überwachung eines Durchstechvorgangs in das Werkstück 208 und zur Ansteuerung der Laserschneidmaschine während des Durchstechvorgangs eingesetzt. Die Laserschneidmaschine umfasst eine bewegbare Laserbearbeitungseinheit (nicht dargestellt) mit einem Laser-Schneidkopf 209, an dem ist die Messelektrode 207 befestigt ist. Zur Einstellung eines vorgegebenen Abstands des Laser-Schneidkopfs 209 zur WerkstückOberfläche ist eine Höhensensorik (nicht dargestellt) vorgesehen, die die Position des Laser-Schneidkopfes 209 und damit der Messelektrode 207 festlegt.

Nachfolgend wird anhand der beschriebenen Laserschneidmaschine das erfindungsgemäße Verfahren erläutert.

Vor Beginn eines Durchstech-Vorgangs wird in einem ersten Schritt die Messelektrode 207 über dem Werkstück 208 derart positioniert, dass die WerkstückOberfläche und die Messelektrode 207 ungefähr einen Abstand zueinander haben, der dem voraussichtlichen späteren Arbeitsabstand während des Durchstech-Vorgangs entspricht.

Der Wechselsignalgenerator 200 erzeugt ein Wechselspannungssignal *U1 (t),* das an dem Werkstück 208 anliegt. Dieses Wechselspannungssignal *U1 (t)* und dessen elektrisches Feld führt dazu, dass in der Messelektrode 207 ein zweites Wechselsignal, nämlich das Wechselstromsignal *I_{1,ϕ} (t)* erzeugt wird. Beide Wechselsignale *U₁ (t)* und *I_{1,ϕ} (t)* weisen gleiche Periodendauern auf; sie unterscheiden sich aber in der Phasenlage, wobei das Wechselstromsignal *I_{1,ϕ} (t)* um den Winkel *ϕ* gegenüber dem ersten Wechselspannungssignal *U₁ (t)* phasenverschoben ist. Die Größe der Phasenverschiebung hängt dabei unter anderem vom Abstand der Messelektrode 207 zum Werkstück 208 ab.

Anschließend wird in einem zweiten Schrittaus Basis der aktuellen Messsignale ein Ausgangswert für die Phasenverschiebung ermittelt. Dieser Wert wird nachfolgend als "Ausgangs-Phasenverschiebungssignalwert" bezeichnet. Zur Ermittlung des Ausgangs-Phasenverschiebungssignalwerts wird das Referenzsignal *U₁ (t)* zunächst mittels des Invertierers 201 invertiert, also um 180° phasengedreht. Der Invertierer 201 liefert als Ausgangssignal ein phasengedrehtes Wechselstromsignal *I_{1,inv} (t).*

Am Phasendiskriminator 202 liegen sowohl das phasengedrehte Wechselstromsignal *I_{1,inv} (t)* als auch das phasenverschobene Wechselstromsignal *I_{1,ϕ} (t)* als Eingangssignale an. Sind die Wechselstromsignale *I_{1,ϕ} (t)* und *I_{1,inv} (t)* nicht zueinander phasenverschoben, heben sich diese bei gleicher Amplitudenhöhe vollständig auf. Im Falle einer Phasenverschiebung resultiert jedoch je nachdem, ob *I_{1,ϕ} (t) I_{1,inv} (t)* voraus- oder nacheilt ein positives oder negatives Phasenverschiebungssignal, das als Ausgangssignal des Phasendiskriminators 202 vorliegt, hier in Form eines Gleichspannungssignals U_{DC}. Der Betrag des Signals ist ein Maß für den Phasenwinkel *Δ_{ϕ},* in dem sich die Phasen der Signale *I_{1,ϕ} (t) I_{1,inv} (t)* unterscheiden. Um einen einfachen Vergleich der Signale *I_{1,ϕ} (t) I_{1,inv} (t)* zu ermöglichen, wird optional mindestens eines der am Phasendiskriminator 202 anliegenden Signale vorverstärkt, um die Amplitudenhöhe beider Signale *I_{1,ϕ} (t) I_{1,inv} (t)* aneinander anzupassen.

Der so ermittelte Ausgangs-Phasenverschiebungssignalwert wird von der elektronischen Schaltung 250 gespeichert und nachfolgend - unter Berücksichtigung eines Toleranzwertes- zur Festlegung des vorgegebenen Schwankungsbereichs verwendet, der zur nachfolgenden Werkstück-Durchstich-Erkennung verwendet wird. Die Höhensensorik der Maschinensteuerung ist dabei deaktiviert, so dass der Abstand zwischen Messelektrode 207 und Werkstück 208 konstant bleibt.

Nach dem Erfassen des Ausgangs-Phasenverschiebungssignalwerts wird mit dem Durchstech-Vorgang begonnen. Hierbei erfolgt ein Energieeintrag in Form von Laserstrahlung in den Werkstück-Bereich des späteren Durchstichs. Die Laserstrahlung wird im Laserschneidkopf fokussiert. Durch den Energieeintrag in das Werkstück 208 wird dieses im Bereich des späteren Durchschnitts aufgeschmolzen. Dabei entsteht auf der Oberseite des Werkstücks 208 eine Plasmakapsel aus elektrisch geladenen Teilchen. Diese Plasmakapsel verursacht eine Änderung der Kapazität zwischen Messelektrode 207 und Oberseite des Werkstücks 208. Darüber hinaus ändert sich der Abstand von Werkstück 208 zur Messelektrode 207 und es können gelöste Werkstückbestandteile in Richtung der Messelektrode 207 beschleunigt werden. All dies trägt dazu bei, dass sich die Phasenverschiebung des Signals *I_{1,ϕ} (t)* gegenüber dem Referenzsignal *I_{1,inv} (t)* während des Durchstechvorgangs laufend ändert. Da sich die Kapazität zwischen Messelektrode 207 und Oberseite des Werkstücks 208 aufgrund des veränderlichen Plasmas im zeitlichen Verlauf verändert, wird während des Durchstech-Vorgangs als Ausgangssignal des Phasendiskriminators 202 ein stark schwankendes Phasenverschiebungssignal U_{DC} erhalten.

Sobald ein Durchstich durch das Werkstück 208 erfolgt ist, verschwindet die Plasmakapsel, wodurch sich das Phasenverschiebungssignal schlagartig zu einem nahezu konstanten Signalwert ändert. Der im Wesentlichen konstante Signalwert des Phasenverschiebungssignals nach dem Durchstich entspricht im Wesentlichen dem Ausgangs-Phasenverschiebungs-signalwert, so dass am Phasenverschiebungssignal und dessen Verlauf ein Durchstich sowohl anhand der Konstanz des Wertes als auch anhand seines Betrages zuverlässig erkannt werden kann. Hierzu wird von der elektronischen Schaltung 250 der zeitliche Verlauf des Phasenverschiebungssignals in einem Zeitintervall erfasst und ausgewertet. Die elektronische Schaltung 250 ist zu diesem Zweck so ausgelegt, dass, wenn in einem von der elektronischen Schaltung ausgewerteten Zeitintervall von 200 ms das Phasenverschiebungssignal innerhalb des vorgegebenen Schwankungsbereichs von ±10 % um den Ausgangs-Phasenverschiebungssignalwert liegt, ein erfolgter Durchstich erkannt wird.

Ist dies der Fall, gibt die elektronische Schaltung 250 beispielsweise ein optisches und/oder akustisches Hinweissignal aus, und sie startet dann ausgehend von dem Durchstich den Schneidvorgang oder sie beendet den Durchstechprozess.

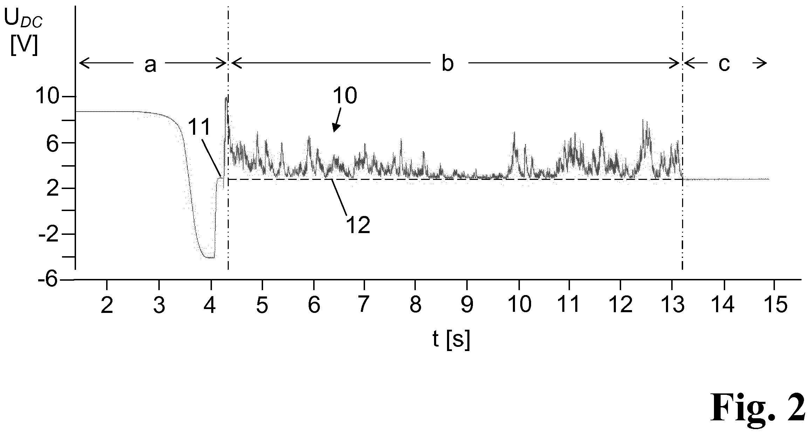

**Figur** 2 zeigt beispielhaft einen typischen zeitlichen Verlauf t (in Sekunden) eines Phasenverschiebungs-Spannungssignals U_{DC} (in V) beim Durchstich durch ein Vollmaterial aus Edelstahl mit einer Materialstärke von 10 mm unter Einsatz der Vorrichtung aus Figur 1.

Dem Signal-Verlauf ist insgesamt die Bezugsziffer 10 zugeordnet. In der Darstellung von Figur 2 ist der Signalverlauf in mehrere Abschnitte a, b, c unterteilt. Abschnitt a kennzeichnet den Signalabschnitt, der dem Verfahren der Messelektrode 207 auf die anfänglich geschätzte Arbeitshöhe entspricht. Hat die Messelektrode 207 diese Arbeitshöhe erreicht, liefert die Vorrichtung einen konstanten Phasenverschiebungssignalwert, der von der elektronischen Schaltung 250 als Ausgangs-Phasenverschiebungssignalwert erfasst wird. Im Signalverlauf 10 ist dieser konstante Signalwert mit der Bezugsziffer 11 bezeichnet.

Abschnitt b des Signal-Verlaufs 10 repräsentiert den Durchstichprozess. Hierbei entsteht - insbesondere aufgrund des Einkoppelns hoher elektrischer Leistung - auf der Oberseite des Werkstücks eine Plasmakapsel, die mit Kapazitätsänderungen und einem schwankenden Phasenverschiebungssignal mit einem hohen Rauschen einhergeht.

Ist der Durchstich erfolgt (Abschnitt c) fällt das Phasenverschiebungssignal merklich ab und das Rauschen verschwindet, so dass ein stabiles, zeitlich etwa konstantes Phasenverschiebungssignal detektiert wird.

Der Durchstich ist somit daran erkennbar, dass das Phasenverschiebungssignal 10 eine geringe Schwankungsbreite aufweist, also in einem Zeitintervall in einem vorgegebenen Zeitintervall innerhalb eines vorgegebenen Schwankungsbereichs liegt, und daran, dass es auf den Ausgangs-Phasenverschiebungssignalwert 11 abfällt. Zusammen liefern beide Kriterien zusammen betrachtet, eine vergleichsweise schnelle und zuverlässige Aussage über den Durchstich.

Zur Vorgabe des Schwankungsbereichs wird der zuvor ermittelte Ausgangs-Phasenverschiebungssignalwert herangezogen. Dieser ist in Figur 2 durch die gestrichelte Linie 12 angedeutet und liefert eine gute Näherung für den zu erwartenden Zielwert. Im Ausführungsbeispiel liegt der vorgegebene Schwankungsbereich bei ± 10% um den Ausgangs-Phasenverschiebungssignalwert.

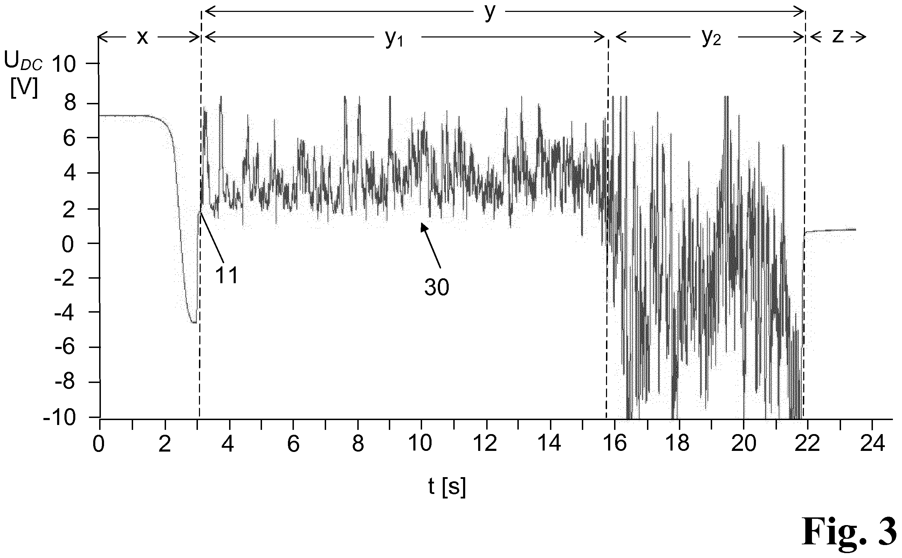

**Figur 3** zeigt einen anderen zeitlichen Verlauf 30 t (in Sekunden) des Phasenverschiebungs-Spannungssignals U_{DC} (in V), wie es beim Durchstechen eines Vollmaterials aus Edelstahl mit einer Materialstärke von 15 mm gemessen worden ist.

Die Messelektrode (207) und der Laserschneidkopf wurden dabei anfänglich einer festen Position zur Werkstückoberfläche gehalten; nämlich in einem Arbeitsabstand von etwa 3,5 mm. Der zeitliche Verlauf 30 des Phasenverschiebungs-Spannungssignals U_{DC} lässt drei Abschnitte x, y, z erkennen, die nachfolgend näher beschrieben sind.

Abschnitt x (entsprechend dem Phasenabschnitt a im Diagramm von Figur. 2) gibt das Phasenverschiebungssignal wieder, wie es beim Verfahren der Messelektrode und des Laserschneidkopfs in die Arbeitshöhe erhalten wird. Der Signalverlauf in Abschnitt x korreliert mit den Abstandsänderungen der Messelektrode zur Werkstückoberfläche.

Sobald die Arbeitshöhe und der konstante Signalwert 11 erreicht waren, wurde mit dem Energie-Eintrag in einen Durchstech-Bereich des Werkstücks begonnen. Hierfür wurde ein gepulster Laser mit 4 kW Leistung bei 25% Tastverhältnis und einer Pulsfrequenz von 70 Hz. Eingesetzt.

Aufgrund des Energie-Eintrags bildete sich auf der Werkstückoberfläche eine Plasmakapsel. Dies führt - wie bereits zu Figur 2 beschrieben - zu einem schwankenden Phasenverschiebungssignal mit hohem Grundrauschen.

Betrachtet man allerdings den Abschnitt y in seiner Gesamtheit, so zeigt das Phasenverschiebungssignal im Verlauf einen Drift hin zu geringeren Spannungen. Insbesondere lassen sich zwei Unterbereiche y₁, y₂ erkennen, die sich in ihrem Phasenverschiebungsmittelwert unterscheiden. Im Unterbereich y1 findet die Plasmabildung im Wesentlichen an der Werkstückoberfläche statt. Mit der Zeit kommt es allerdings zu einer zunehmenden Materialaufschmelzung im Durchstechbereich und damit einhergehend zu einer räumlichen Verschiebung der Plasmabildung und der Plasmakapsel in Richtung zur Werkstückmitte. Hierdurch ändert sich der Einfluss der Plasmakapsel auf das Phasenverschiebungssignal, so dass sich dieses zu geringeren Spannungen hin verschiebt (Bereich y₂). Dieses Phänomen zeigt sich besonders stark bei Werkstücken mit größeren Materialstärken, in der Regel bei Materialstärken oberhalb von 10 mm.

Die Änderung des Phasenverschiebungssignals im Bereich y₂ kann vorteilhaft für die Ansteuerung des Lasers genutzt werden. Dadurch, dass sich im Verlauf des Durchstech-Vorgangs die Plasmakapsel räumlich zur Werkstückmitte hin verschiebt, können bei Auftreten größerer Phasenverschiebungssignal-Schwankungen und/oder einer Phasenverschiebungssignal-Drift, die Leistungsparameter Lasers angepasst oder vorzugsweise des Ansteuerung des Lasers derart geändert werden, dass die Fokuslage des Lasers der geänderten Plasmaposition nachgeführt wird. Dies kann beispielsweise geschehen,
a) indem die Arbeitshöhe verringert wird, oder
b) bevorzugt, indem die Fokuslage verändert wird, beispielsweise indem die Fokuslage in Richtung zur Werkstück-Unterseite hin verschoben wird.

Alternativ kann auch die Leistung des Lasers selbst, dessen Pulsfrequenz, Tastverhältnis oder der Gasdruck verändert werden.

Die vorgenannten Maßnahmen tragen dazu bei, dass eine besonders hohe Durchstechgüte erreicht wird.

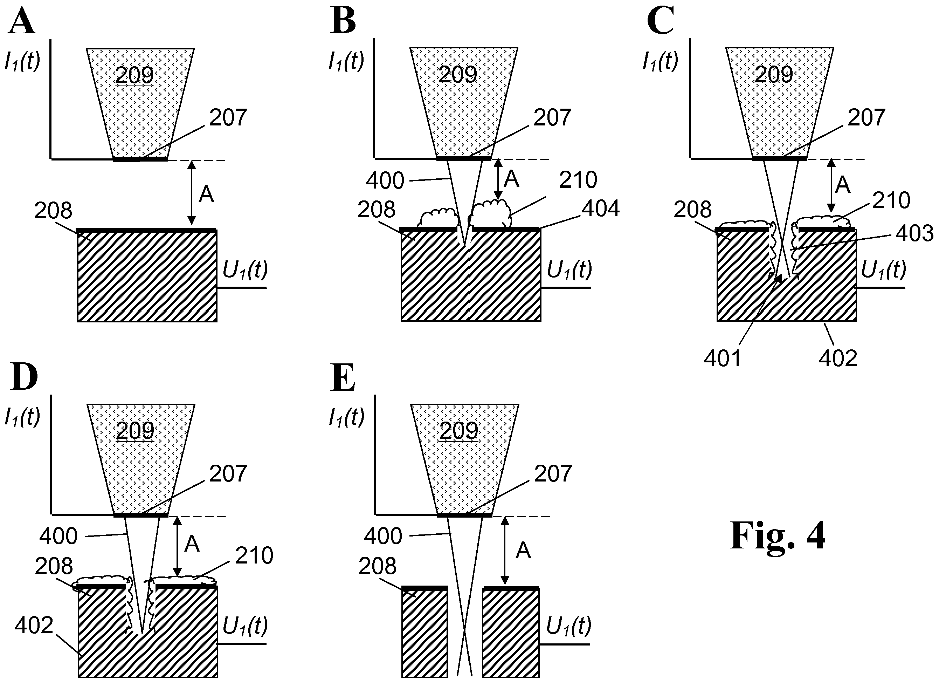

In den **Figuren 4A** - **4E** sind zur Erläuterung des Verfahrens zur Durchstich-Erkennung eine Anordnung aus Werkstück und Vorrichtung zur Durchsticherkennung in zeitlicher Abfolge vor, während und nach einem Durchschnitt dargestellt.

**Figur 4A** zeigt eine Anordnung aus Werkstück 208 und einem Laserschneidkopf 209, an dem eine Messelektrode 207 angebracht ist. Die Anordnung in Figur 4A erfasst den Ausgangs-Phasenverschiebungssignalwert. Hierzu befindet sich der Laserschneidkopf 209 auf Arbeitshöhe, ein Energieeintrag in das Werkstück findet nicht statt.

Am Werkstück 208 liegt ein Wechselspannungssignal *U1 (t)* an, das in der Messelektrode 207 ein phasenverschobenes, zweites Wechselsignal erzeugt, nämlich das Wechselstromsignal *I_{1,ϕ}* (t). Beide Wechselsignale *U₁ (t)* und *I_{1,ϕ} (t)* liegen der Ermittlung des Ausgangs-Phasenverschiebungssignalwerts zugrunde.

**Figur 4B** zeigt dieselbe Anordnung während eines Energieeintrags mittels Laserstrahlung 400 in das Werkstück 208. Auf der Oberseite 404 des Werkstücks 208 hat sich eine Plasmakapsel 210 gebildet. Die Plasmakapsel 210 hat Einfluss auf die Phasenverschiebung der Wechselsignale *U₁ (t)* und *I_{1,ϕ} (t)* und damit auf das Phasenverschiebungssignal. Das Phasenverschiebungssignal als Maß für den Abstand A zeigt während dieses Verfahrensschritts ein gewisses Rauschen, wie beispielsweise in Figur 2, Abschnitt b, oder in Figur 3, Abschnitt y dargestellt.

Wie **Figur 4C** zeigt, bildet sich während des Durchstech-Vorgangs zunehmend ein Einstich 403 in das Werkstück 208 aus. Dabei verlagert sich der Schneidpunkt 401 von der Messelektrode 207 weg in Richtung Werkstück-Unterseite 402. Gleichzeitig verringert sich die Höhe, mit der die Plasmakapsel 210 die Oberseite 404 des Werkstücks 208 überragt; der scheinbare Abstand A wird wieder größer. Dieser Vorgang geht mit einer Drift des Phasenverschiebungssignals einher. Eine solche Drift ist beispielsweise im Phasenverschiebungssignal 30 von Figur 3, Abschnitt y₂ zu erkennen. Wird eine Drift im Phasenverschiebungssignal erkannt, kann dies als Grundlage für eine Neu-Fokussierung des Lasers verwendet werden.

**Figur 4D** zeigt die Anordnung aus Figur 4C, bei der die Fokuslage des Laserstrahls 400 in Richtung zur Werkstück-Unterseite 402 hin verschoben ist. Eine solche Anpassung der Fokuslage hat den Vorteil, dass eine besonders hohe Schnittgüte erhalten wird.

In **Figur 4E** ist der Durchstich erfolgt. Der Laserstrahl 400 passiert das Werkstück im Bereich des Durchstichs ungehindert.

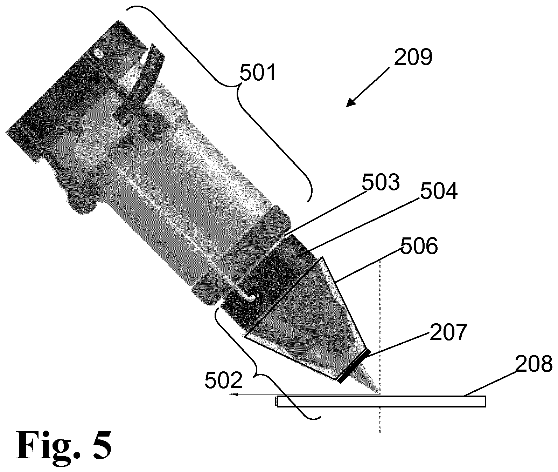

In **Figur 5** ist der Laserschneidkopf 209 detaillierter dargestellt. Der Laserschneidkopf 209 ist in einen oberen Teil 501 und einen unteren Teil 502 untergliedert. Der obere Teil 501 ist mit der Masse einer Laserschneidmaschine (nicht dargestellt) verbunden. Der untere Teil 502 umfasst eine Schneiddüse 504 und die daran angebrachte Messelektrode 207. Liegt an einem Werkstück 208 eine Wechselspannung an, so erzeugt diese in der Messelektrode 207 ein phasenverschobenes Wechselsignal. Da der obere Teil des Laserschneidkopfs 209 mit der Masse der Laserschneidmaschine verbunden ist, ist es notwendig, den oberen Teil 501 und den unteren Teil 502 des Laserschneidkopfs 209 durch einen Isolator 503 elektrisch voneinander zu trennen.

Die Genauigkeit des erfassten Phasenverschiebungssignals kann von Unregelmäßigkeiten des Werkstücks 208 oder von Fremdkapazitäten beeinträchtigt werden. Unregelmäßigkeiten in diesem Sinne können beispielsweise durch den Werkstückrand, die Werkstückform oder Ausschnitten aus dem Werkstück hervorgerufen werden. Fremdkapazitäten können ihre Ursache beispielsweise in der Fasenlage des Laserschneidkopfes 209 während des Durchstech-Vorgangs und der damit verbundenen Annäherung des Laserschneidkopfes 209 an das Werkstück 208 haben. Diese Effekte können die genaue Erfassung eines Werkstück-Durchstichs beeinträchtigen.

Um derartige Einflüsse auf das Messergebnis, hier das Phasenverschiebungssignal, zu minimieren, ist der Laserschneidkopf 209 mit einem Abschirmelement 506 versehen. Das Abschirmelement 506 ist als Schirmelektrode ausgebildet und der Schneiddüse 504 zugeordnet. Es ist kegelförmig und umgibt die Schneiddüse 504 entlang ihrer Seitenflächen. Dies hat den Vorteil, dass der Laserschneidkopf 209 auch über bereits geschnittenen Innenkonturen oder in der Nähe der WerkstüccKante angeordnet werden kann, ohne dass diese das Messergebnis wesentlich beeinträchtigen. Darüber hinaus kann die Position des Laserschneidkopfes 209 relativ zum Werkstück 208 während des Durchstechvorgangs verändert werden, ohne dass dadurch die Erfassung des Durchstichs wesentlich beeinträchtigt wird.

Die zuvor beschriebene, erfindungsgemäße Vorrichtung kann gleichzeitig dazu verwendet werden, einen Schnittabriss zu erkennen. Beispielsweise schließt sich an den Durchstich-Vorgang unmittelbar ein Schneidvorgang an. In diesem Fall kann die Vorrichtung als Schnittabrisserkennungs-Vorrichtung verwendet werden.

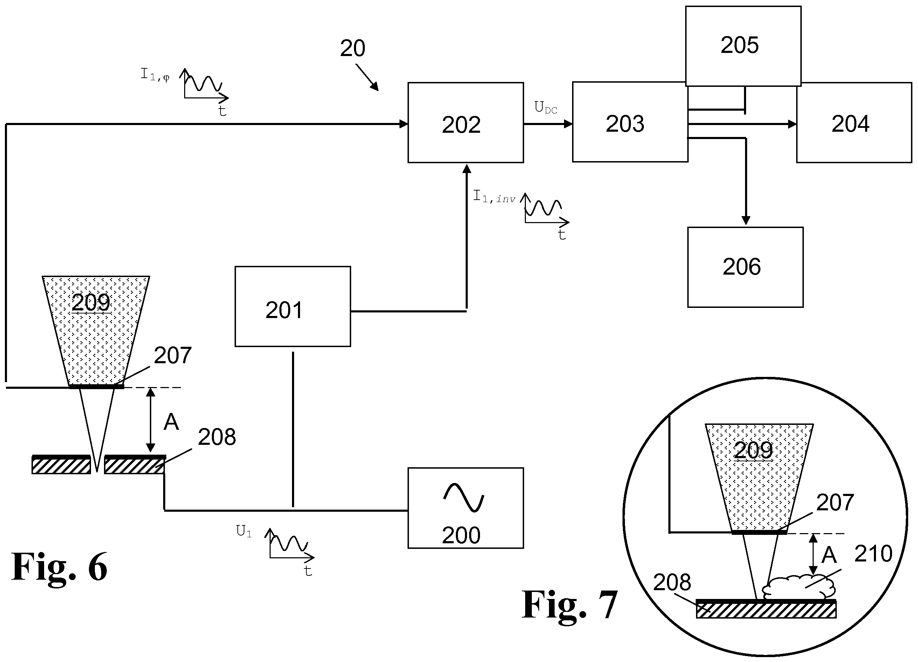

**Figur 6** zeigt ein schematisches Schaltbild einer erfindungsgemäßen Vorrichtung 20 aus Figur 1, die als Schnittabrisserkennungs-Vorrichtung verwendet wird.

Die Vorrichtung 20 umfasst einen Wechselsignalgenerator 200, eine Messelektrode 207, einen Invertierer 201, einen Phasendiskriminator 202, eine KontrollEinheit 203 sowie drei unabhängige elektronische Schaltungen 204, 205, 206.

Die Vorrichtung 20 ist Teil einer Laserschneidmaschine (nicht dargestellt), wie sie beispielsweise zum Schneiden eines ebenen Werkstücks 208 aus Metall, vorzugsweise aus Edelstahl, Aluminium, Kupfer oder Messing, eingesetzt wird.

Nachfolgend wird anhand der oben beschriebenen Laserschneidmaschine das Schnittabrisserkennungs-Verfahren erläutert.

Zunächst wird das Werkstück 208 mit einem Wechselspannungssignal *U1 (t)* beaufschlagt. Hierzu erzeugt der Wechselsignalgenerator 200 das Wechselspannungssignal *U1 (t),* das an dem Werkstück 208 anliegt und nachfolgend als Referenzsignal verwendet wird.

Das Wechselspannungssignal *U₁ (t)* ruft in der Messelektrode 207 ein Wechselstromsignal *I_{1,ϕ} (t)* hervor. Beide Wechselsignale *U₁ (t)* und *I_{1,ϕ} (t)* weisen gleiche Periodendauern auf; sie unterscheiden sich allerdings in der Phasenlage, wobei das Wechselstromsignal *I_{1,ϕ} (t)* um den Winkel *ϕ* gegenüber dem ersten Wechselspannungssignal *U₁ (t)* phasenverschoben ist. Die Größe der Phasenverschiebung hängt dabei unter anderem vom Abstand der Messelektrode 207 zum Werkstück 208 ab. Mittels der Messelektrode 207 wird das Wechselstromsignal *I_{1,ϕ} (t)* erfasst.

Unter normalen Schnittbedingungen wird der Abstand zwischen Messelektrode 207 zum Werkstück 208 durch die Höhensensorik -von Regelabweichungen abgesehen - möglichst konstant gehalten. Das hieraus resultierende Wechselstromsignal *I_{1,ϕ} (t)* weist zwar ein gewisses Rauschen auf, zeigt aber eine zeitlich nahezu konstante Phasenverschiebung gegenüber dem Referenzsignal *U₁ (t).*

Zur Ermittlung der Phasenverschiebung wird das Referenzsignal *U₁ (t)* zunächst mittels des Invertierers 201 invertiert, also um 180° phasengedreht. Der Invertierer 201 liefert als Ausgangssignal ein phasengedrehtes Wechselstromsignal *I_{1,inv} (t).*

Am Phasendiskriminator 202 liegen sowohl das phasengedrehte Wechselstromsignal *I_{1,inv} (t)* als auch das phasenverschobene Wechselstromsignal *I_{1,ϕ} (t)* als Eingangssignale an. Der Phasendiskriminator 202 beinhaltet auch einen Gleichrichter. Sind die Wechselstromsignale *I_{1,ϕ} (t)* und *I_{1,inv} (t)* nicht zueinander phasenverschoben, heben sich diese bei gleicher Amplitudenhöhe vollständig auf. Im Falle einer Phasenverschiebung resultiert jedoch je nachdem, ob *I_{1,ϕ} (t) I_{1,inv} (t)* voraus- oder nacheilt ein positives oder negatives Phasenverschiebungssignal in Form des Gleichspannungssignals U_{DC}. Der Betrag des Signals ist ein Maß für den Phasenwinkel *Δ_{ϕ}*, in dem sich die Phasen der Signale unterscheiden. Um einen einfachen Vergleich der Signale zu ermöglichen, wird optional mindestens eines der am Phasendiskriminator 202 anliegenden Signale vorverstärkt (nicht dargestellt), um die Amplitudenhöhe beider Signale aneinander anzupassen.

Anschließend wird das Phasenverschiebungssignal U_{DC} von der Kontrolleinheit 203 mit einem vorgegebenen oberen und unteren Grenzwert verglichen.

Im normalen Schneidbetrieb werden die Grenzwerte regelmäßig nicht über- oder unterschritten. Kommt es allerdings zu einem Schnittabriss, so entsteht auf der Oberseite des Werkstücks 208 eine Plasmakapsel 210. Diese Plasmakapsel 210 entsteht maßgeblich durch das Einkoppelns hoher Leistungsspitzen in das Werkstück 208.

**Figur** 7 zeigt den Laser-Schneidkopf 209, das Werkstück 208 und die Plasmakapsel 210 im Falle eines Schnittabrisses. Die dabei entstehende Plasmakapsel 210 verursacht eine Änderung der Kapazität zwischen Messelektrode 207 und Oberseite des Werkstücks 208. Darüber hinaus werden gelöste Werkstückbestandteile aufgrund der nicht mehr das Material durchdringenden Schnittfuge in Richtung der Düse beziehungsweise der Messelektrode 207 beschleunigt. Hieraus resultiert eine geänderte Phasenverschiebung der Signale *I_{1,ϕ} (t)* und *I_{1,inv} (t).* Da sich die Kapazität zwischen Messelektrode 207 und Oberseite des Werkstücks 208 aufgrund des veränderlichen Plasmas sich im zeitlichen Verlauf ändert und schwankt, wird auch als Ausgangssignal des Phasendiskriminators 202 ein schwankendes Phasenverschiebungssignal U_{DC} erhalten, das zur Detektion des Schnittabrisses verwendet wird. Dazu wird das Phasenverschiebungssignal von der Kontrolleinheit 203 auf das Überschreiten eines oberen oder das Unterscheiten eines unteren Grenzwerts hin überwacht. Im Fall des Über- oder Unterschreitens des jeweiligen Grenzwerts wird:
- mittels der elektronischen Schaltung 204 die Trenngeschwindigkeit reduziert,
- mittels der elektronischen Schaltung 205 die Messelektrode auf eine vorgegebene feste Position eingestellt, und
- mittels der elektronischen Schaltung 206 ein optisches und akustisches Warnsignal ausgegeben.

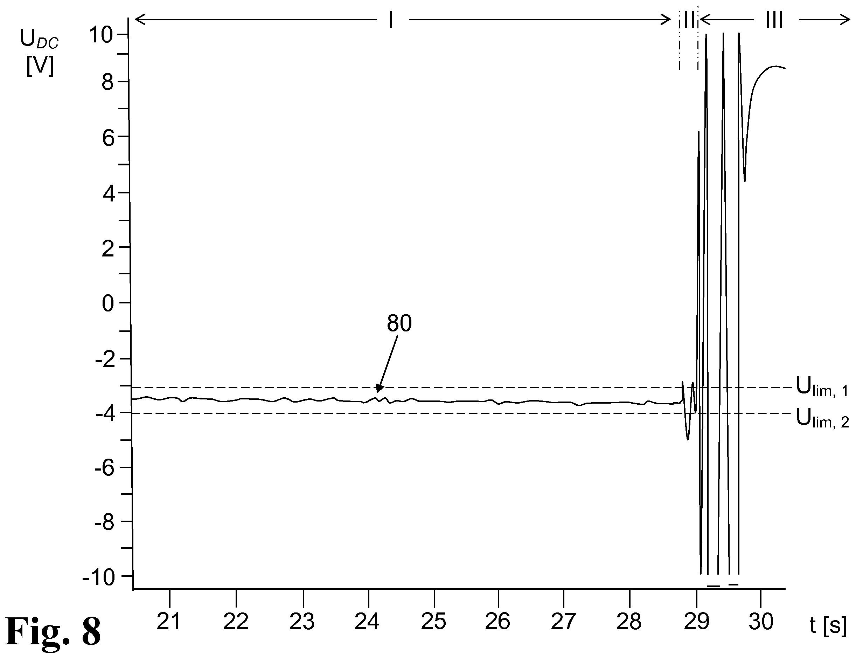

**Figur** 8 zeigt beispielhaft einen zeitlichen Verlauf des Phasenverschiebungs-Spannungssignals U_{DC} bei einem guten Schnitt (Abschnitt I), einem drohenden Schnittabriss (Abschnitt II) und nach erfolgtem Schnittabriss (Abschnitt III) Das Phasenverschiebungssignal ist mit der Bezugsziffer 80 gekennzeichnet.

Vor dem Schnittabriss weist Phasenverschiebungssignal 80 ein während des Schneidvorgangs übliches Rauschen auf. Dennoch ist das Phasenverschiebungssignal 1 im Abschnitt I im Wesentlichen konstant und schwankt mit nur einer geringen Abweichung um einen Mittelwert. Ein drohender Schnittabriss führt zu einem Aufschwingen des Phasenverschiebungssignals 80 in Abschnitt II bis hin zum Vollausschlag in Abschnitt III.

Um einem drohenden Schnittabriss erfolgreich entgegenwirken zu können und dadurch einen Schnittabriss zu vermeiden, ist es wichtig, einen beginnenden Schnittabriss möglichst frühzeitig zu erkennen. Der Einsatz des Phasenverschiebungssignals ermöglicht insbesondere in Abschnitt II eine frühzeitige Schnittabrisserkennung. Der obere Grenzwert U_{lim,1} und der untere Grenzwert U_{lim,2} sind so gewählt, dass sie eine frühzeitige Erkennung ermöglichen.

## Patentansprüche

1. Verfahren zur Durchstich-Erkennung beim thermisch-unterstützten Durchstechen eines Werkstücks (208), bei dem das Werkstück (208) mit einem ersten Wechselsignal beaufschlagt wird, **gekennzeichnet durch** die Verfahrensschritte:
a) Erfassen eines von dem ersten Wechselsignal in einer vom Werkstück (208) beabstandeten Messelektrode (207) hervorgerufenen, zweiten Wechselsignals,
b) Ermitteln der Phasenverschiebung zwischen erstem und zweitem Wechselsignal unter Ausgabe eines Phasenverschiebungssignals (10; 30),
c) Erfassen eines zeitlichen Verlaufs des Phasenverschiebungssignals (10; 30) oder einer daraus abgeleiteten Messgröße in einem vorgegebenen Zeitintervall,
wobei ein erfolgter Werkstück-Durchstich daran erkannt wird, dass das Phasenverschiebungssignal (10; 30) oder die daraus abgeleitete Messgröße im Zeitintervall innerhalb eines vorgegebenen Schwankungsbereichs liegt.

2. Verfahren nach Anspruch 1, **dadurch gekennzeichnet, dass** die Messelektrode (207) während des thermisch-unterstützten Durchstechens in einem konstanten Arbeitsabstand zum Werkstück (208) gehalten wird.

3. Verfahren nach Anspruch 2, **dadurch gekennzeichnet, dass** vor dem thermischen Durchstechen mit der auf Arbeitsabstand gehaltenen Messelektrode (207) ein Ausgangs-Phasenverschiebungssignalwert bestimmt wird, und dass der vorgegebene Schwankungsbereich den Ausgangs-Phasenverschiebungssignalwert umfasst.

4. Verfahren nach Anspruch 3, **dadurch gekennzeichnet, dass** der vorgegebene Schwankungsbereich einen dem Ausgangs-Phasenverschiebungssignalwert entsprechenden Mittelwert aufweist, wobei der vorgegebene Schwankungsbereich in einem Bereich von ± 5% bis ±15% bezogen den Mittelwert liegt.

5. Verfahren nach Anspruch 1 oder 2, **dadurch gekennzeichnet, dass** gemäß Verfahrensschritt c) die Varianz des Phasenverschiebungssignals (10; 30) im vorgegebenen Zeitintervall als abgeleitete Messgröße erfasst wird.

6. Verfahren nach Anspruch 1 oder 2, **dadurch gekennzeichnet, dass** gemäß Verfahrensschritt c) die erste zeitliche Ableitung des Phasenverschiebungssignals (10; 30) im vorgegebenen Zeitintervall erfasst und als abgeleitete Messgröße verwendet wird.

7. Verfahren nach einem der vorhergehenden Ansprüche, **dadurch gekennzeichnet, dass** beim thermisch-unterstützten Durchstechen des Werkstücks (208) mittels einer Bearbeitungseinheit ein Energieeintrag in einen Einstichkrater erfolgt, und dass eine Überwachung des Durchstechens dergestalt erfolgt, dass, wenn der gemäß Verfahrensschritt c) erfasste zeitliche Verlauf im vorgegebenen Zeitintervall einen vorgegebenen Höchstschwankungsbereich überschreitet oder wenn im zeitlichen Verlauf gemäß Verfahrensschritt c) ein Spitzenwert oberhalb eine vorgegebenen Spitzenhöchstwerts erfasst wird, der Energieeintrag in den Einstichkrater verändert wird.

8. Verfahren nach Anspruch 7, **dadurch gekennzeichnet, dass**, wenn die Bearbeitungseinheit einen Laser umfasst, der Energieeintrag in den Einstichkrater verändert wird, indem Fokuslage, Pulsfrequenz, Leistung und/oder Tastverhältnis des Lasers verändert werden.

9. Verfahren nach Anspruch 7, **dadurch gekennzeichnet, dass**, wenn die Bearbeitungseinheit einen Schneidbrenner umfasst, der Energieeintrag in den Einstichkrater verändert wird, indem Gasdruck, vorzugsweise ein Schneidgasdruck, verändert wird.

10. Vorrichtung (20) zur Durchstich-Erkennung beim thermisch-unterstützten Durchstechen eines Werkstücks (208), aufweisend einen Wechselsignal-Generator (200) zum Erzeugen eines ersten Wechselsignals, **dadurch gekennzeichnet, dass** sie eine vom Werkstück (208) beabstandete Messelektrode (207) zur Erfassung eines von dem ersten Wechselsignal hervorgerufenen zweiten Wechselsignals, einen Phasen-Diskriminator (202) zur Ermittlung einer Phasenverschiebung zwischen dem ersten und dem zweiten Wechselsignal, der ein Phasenverschiebungssignal (10; 30) ausgibt, umfasst, und eine elektronische Schaltung (250) zur Erfassung eines zeitlichen Verlauf des Phasenverschiebungssignals (10; 30) oder einer daraus abgeleiteten Messgröße vorgesehen und derart ausgelegt ist, dass als Werkstück-Durchstich identifiziert wird, wenn das Phasenverschiebungssignal (10; 30) oder die daraus abgeleitete Messgröße in einem vorgegebenen Zeitintervall innerhalb eines vorgegebenen Schwankungsbereichs liegt.

## Claims

1. A method for through-cut detection in thermally-assisted through cutting of a workpiece (208), comprising subjecting the workpiece (208) to a first alternating electrical signal, **characterized by** the method steps:
a) detecting a second alternating electrical signal caused by the first alternating electrical signal in a measurement electrode (207) spaced from the workpiece (208),
b) determining a phase shift between the first and second alternating electrical signal so as to produce output of a phase shift signal (10; 30),
c) detecting a progression over time of the phase shift signal (10; 30) or a measurement variable derived therefrom in a predetermined time interval,
wherein determining that a workpiece through-cut has been made responsive to t the phase shift signal (10; 30) or the measurement variable derived therefrom being within a predetermined fluctuation range in the predetermined time interval.

2. Method according to claim 1, **characterized in that** the measurement electrode (207) is kept at a constant work distance from the workpiece (208) during the thermally-assisted through-cutting operation.

3. Method according to claim 2, **characterized in that** prior to the thermal through-cut with the measurement electrode (207) kept at the work distance, an initial phase-shift signal value is determined, and wherein the initial phase-shift signal value is in the predetermined fluctuation range.

4. Method according to claim 3, **characterized in that** the predetermined fluctuation range has a mean value corresponding to the initial phase-shift signal value, wherein the predetermined fluctuation range is in a range of ± 5% to ±15% based on the mean value.

5. Method according to claim 1 or 2, **characterized in that** the detecting of the progression over time is of the measurement value derived from the phase shift signal, and said measurement signal is derived as a variance of the phase shift signal (10; 30) in the predetermined time interval.

6. Method according to claim 1 or 2, **characterized in that** in the detecting of the progression over time is of the measurement value derived from the phase shift signal and said measurement signal is derived as a first time derivative of the phase shift signal (10; 30) in the predetermined time interval.

7. Method according to claim 1, **characterized in that** in the thermally-assisted through-cutting of the workpiece (208) is done using a treatment unit, and an energy input is made into an incision crater, and that the through-cutting operation is monitored such that when the progression over time detected according to method step c) in the predetermined time interval exceeds a predetermined maximum fluctuation range or when in the progression over time according to method step c) a peak value is detected above a predetermined peak maximum value, the energy input into the incision crater is changed.

8. Method according to claim 7, **characterized in that** when the treatment unit comprises a laser, and the energy input into the incision crater is changed by changing a focal position, pulse frequency, power and/or duty cycle of the laser.

9. Method according to claim 7, **characterized in that** when the treatment unit comprises a cutting torch, and the energy input into the incision crater is changed by changing gas pressure of said cutting torch.

10. Apparatus (20) for through-cut detection in the thermally-assisted through-cutting of a workpiece (208), said apparatus comprising an alternating signal electrical signal generator (200) generating a first alternating signal, **characterized in that** it comprises a measurement electrode (207) spaced from the workpiece (208) for detecting a second alternating signal electrical signal caused by the first alternating signal, a phase discriminator (202) determining a phase shift between the first and the second alternating signal, wherein said discriminator outputs a phase shift signal (10; 30), and an electronic circuit (250) for detecting a progression over time of the phase shift signal (10; 30) or of a measurement variable derived therefrom, said electronic circuit being configured so as to identify a workpiece through-cut responsive to the phase shift signal (10; 30) or to the measurement variable derived therefrom being within a predetermined fluctuation range in a predetermined time interval.

## Revendications

1. Procédé d'identification de perforation lors de la perforation thermique d'une pièce (208), où la pièce (208) est soumise à l'action d'un premier signal alternatif, **caractérisé par** les étapes de procédé:
a) de détection d'un deuxième signal alternatif entraîné par le premier signal alternatif dans une électrode de mesure (207) tenue à distance de la pièce (208),
b) de détermination du décalage de phase entre un premier et un deuxième signal alternatif en émettant un signal de décalage de phase (10 ; 30),
c) de détection d'une évolution temporelle du signal de décalage de phase (10 ; 30) ou d'une grandeur de mesure dérivée sur cette base dans un intervalle de temps prédéfini,
dans lequel une perforation de pièce réalisée avec succès est identifiée en ce que le signal de décalage de phase (10 ; 30) ou la grandeur de mesure dérivée sur cette base se situe dans l'intervalle de temps dans une plage de fluctuation prédéfinie.

2. Procédé selon la revendication 1, **caractérisé en ce que** l'électrode de mesure (207) est maintenue pendant la perforation thermique à une distance de travail constante par rapport à la pièce (208).

3. Procédé selon la revendication 2, **caractérisé en ce qu'**avant la perforation thermique, une valeur de signal de décalage de phase de sortie est définie avec l'électrode de mesure (207) maintenue à une distance de travail, et que la plage de fluctuation prédéfinie comprend la valeur de signal de décalage de phase de sortie.

4. Procédé selon la revendication 3, **caractérisé en ce que** la plage de fluctuation prédéfinie présente une valeur moyenne correspondant à la valeur de signal de décalage de phase de sortie, dans lequel la plage de fluctuation prédéfinie se situe dans une plage de ± 5 % à ± 15 % par rapport à la valeur moyenne.

5. Procédé selon la revendication 1 ou 2, **caractérisé en ce que** selon l'étape de procédé c), la variance du signal de décalage de phase (10 ; 30) est détectée dans l'intervalle de temps prédéfini en tant que grandeur de mesure dérivée.

6. Procédé selon la revendication 1 ou 2, **caractérisé en ce que** selon l'étape de procédé c), la première dérivée temporelle du signal de décalage de phase (10 ; 30) est détectée dans l'intervalle de temps prédéfini et est utilisée en tant que grandeur de mesure dérivée.

7. Procédé selon l'une quelconque des revendications précédentes, **caractérisé en ce que** lors de la perforation thermique de la pièce (208) au moyen d'une unité d'usinage, un apport en énergie est effectué dans un cratère d'accès, et qu'une surveillance de la perforation est effectuée de telle manière que, quand l'évolution temporelle détectée selon l'étape de procédé c) dépasse, dans l'intervalle de temps prédéfini, une plage de fluctuation maximale prédéfinie ou quand lors de l'évolution temporelle selon l'étape de procédé c), une valeur de pic est détectée au-dessus d'une valeur maximale de pic prédéfinie, l'apport en énergie dans le cratère d'accès est modifié.

8. Procédé selon la revendication 7, **caractérisé en ce que**, quand l'unité d'usinage comprend un laser, l'apport en énergie dans le cratère d'accès est modifié **en ce que** la position du point focal, la fréquence d'impulsion, la puissance et/ou le rapport cyclique du laser sont modifiés.

9. Procédé selon la revendication 7, **caractérisé en ce que**, quand l'unité d'usinage comprend un chalumeau, l'apport en énergie dans le cratère d'accès est modifié **en ce que** la pression de gaz, de préférence une pression de gaz de coupe, est modifiée.

10. Dispositif (20) servant à identifier une perforation lors de la perforation thermique d'une pièce (208), présentant un générateur de signaux alternatifs (200) servant à produire un premier signal alternatif, **caractérisé en ce qu'**il comprend une électrode de mesure (207) tenue à distance de la pièce (208) servant à détecter un deuxième signal alternatif entraîné par le premier signal alternatif, un discriminateur de phases (202) servant à déterminer un décalage de phase entre le premier et le deuxième signal alternatif, qui émet un signal de décalage de phase (10 ; 30), et un circuit électronique (250) servant à détecter une évolution temporelle du signal de décalage de phase (10 ; 30) ou une grandeur de mesure dérivée sur cette base et est configuré de telle manière qu'une perforation de pièce est identifiée quand le signal de décalage de phase (10 ; 30) ou la grandeur de mesure dérivée sur cette base se situe dans un intervalle de temps prédéfini à l'intérieur d'une plage de fluctuation prédéfinie.
